Europäisches Patentamt

European Patent Office

Office européen des brevets

(19)

(11) **EP 1 239 290 A2**

(12) **EUROPEAN PATENT APPLICATION**

(43) Date of publication:
**11.09.2002 Bulletin 2002/37**

(51) Int Cl.⁷: **G01R 19/145**

(21) Application number: **02005043.1**

(22) Date of filing: **06.03.2002**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **09.03.2001 JP 2001066597
29.06.2001 JP 2001197805
17.01.2002 JP 2002008497**

(71) Applicant: **TOKYO ELECTRIC POWER COMPANY
Tokyo 100-0011 (JP)**

(72) Inventor: **Kitamura, Satoshi,
c/o Tokyo Electric Power Co.
Yokohama-shi, Kanagawa-ken, 230-8510 (JP)**

(74) Representative: **Kuhnen & Wacker
Patentanwaltsgesellschaft mbH,
Prinz-Ludwig-Strasse 40A
85354 Freising (DE)**

(54) **Apparatus for detecting voltage and current status in electric power system**

(57)  A contactless apparatus for detecting voltage and current statuses on conductors of electrical equipment in an electric power system. The apparatus detects whether the conductors are in a voltage mode or a current mode by detecting vibrations of the conductors from a distance. The apparatus irradiates a laser beam on the conductors, detects the vibration, and provides result to an output unit such as a display. In addition, a vibration is forcefully produced on the conductors upon irradiating an electromagnetic wave of selected frequency by an electromagnetic wave generator of the apparatus.

Fig. 1

**Description**

BACKGROUND OF THE INVENTION

Field of the Invention

The present invention relates to an apparatus for detecting voltage and current statuses on conductors of an electric power system, and more particularly, to a contactless apparatus for detecting voltage and current statuses on conductors of electrical equipment in the electric power system.

Description of the Related Art

Typically, an electric power system includes electric stations such as substations and switching stations, where electrical equipment such as transformers and switches are installed. Such electrical equipment in the electric stations are inspected when an accident arises or at a time of regular inspection.

During such inspection, a worker first checks if the electrical equipment subject to the inspection is in a high voltage or current flowing condition. Here, within the context of the present invention, a status of conductors of the electrical equipment where a high voltage is applied thereto but current is not flowing is defined as a "voltage mode" and a status of the conductors where a high voltage is applied thereto and current is flowing is defined as a "current mode". The worker advises the other workers not to inadvertently approach the electrical equipment which is either in the voltage mode or current mode to ensure safety.

Today, as a method for detecting the voltage mode of the electrical equipment, various detectors and potential transformers (PT) or potential devices (PD) are used. A detector is comprised of an insulating bar where a detection element such as a neon bulb is provided at its end. By contacting the neon bulb with a conductor of the electrical equipment, it is determined whether it is in a voltage mode or not. Further, a potential transformer (or potential device) reduces the voltage of cables running to the conductors of the electrical equipment to measure the voltage of the conductors, and determines if the electrical equipment is in the voltage mode or not.

Meanwhile, as a method for detecting the current mode in the conductors of the electrical equipment, various galvanometers and current transformers (CT) are used. A galvanometer is comprised of an insulating bar having a detection element with a U-shaped ferromagnetic coil at its end. By bringing the detection element close to the conductor of the electrical equipment, the amount of current flowing in the conductor is measured. Further, a current transformer is connected to the conductor of the electrical equipment in series to detect and measure the amount of current flowing through the conductor.

In such a conventional technology, however, when using the detector for examining the voltage mode or when using the galvanometer for examining the current mode of the electrical equipment, a higher dielectric strength (insulation proof) is required for such detector and galvanometer when the voltage in the electrical equipment is higher. Accordingly, the detector and galvanometer have to be large and heavy. Therefore, detecting the voltage mode or current mode in the conductors of the electrical equipment in high places becomes difficult.

Further, when using the potential transformer for examining the voltage mode or when using the current transformer for examining the current mode of the electrical equipment, these transformers have to be installed in the electrical equipment prior to use, which limits locations of detecting points. Also, these potential and current transformers require a higher dielectric strength as the voltage handled by the electric equipment becomes higher, resulting in the increase in cost.

SUMMARY OF THE INVENTION

Therefore, it is an object of the present invention to provide an apparatus for detecting a voltage mode or current mode of the electrical equipment from a distance without contacting the electrical equipment so long as the electrical equipment is visible.

The above noted object is achieved by the apparatus of the present invention configured as follows:

In one aspect of the present invention, an apparatus for detecting a voltage and current status of conductors of electrical equipment as to whether in a voltage mode or a current mode is comprised of:

   a vibration detector for irradiating a wave on the conductors of the electrical equipment and detecting a vibration of the conductors based on a frequency of an incident wave and a frequency of a reflected wave;
   a processor for determining either the voltage mode or current mode when an amplitude of a specific frequency extracted from the vibration of the conductors exceeds a predetermined value; and
   an output unit for indicating the voltage mode or current mode determined by the processor.

In another aspect of the present invention, an apparatus for detecting a voltage and current status of conductors of electrical equipment as to whether in a voltage mode or a current mode is comprised of:

an electromagnetic wave generator for irradiating an electromagnetic wave of a selected frequency on the conductors of the electrical equipment and detecting a vibration of the conductors based on a frequency of an incident wave and a frequency of a reflected wave;
a processor for determining either the voltage mode or current mode when an amplitude of a specific frequency extracted from the vibration of the conductors exceeds a predetermined value; and
an output unit for indicating the voltage mode or current mode determined by the processor.

In a further aspect of the present invention, an apparatus for detecting a voltage and current status of conductors of electrical equipment as to whether in a voltage mode or a current mode is comprised of:

a vibration detector for irradiating an electromagnetic wave of a selected frequency on the conductors of the electrical equipment and detecting a vibration of the conductors based on a frequency of an incident wave and a frequency of a reflected wave;
a processor for determining either the voltage mode or current mode when an amplitude of a specific frequency extracted from the vibration of the conductors exceeds a predetermined value; and
an output unit for indicating the voltage mode or current mode determined by the processor.

BRIEF DESCRIPTION OF THE DRAWINGS

Figure 1 is an outside view of an apparatus for detecting voltage and current status associated with the first embodiment of the present invention.
Figure 2 is a block diagram of the processor used in all of the embodiments of the present invention.
Figure 3 is a schematic diagram for explaining the principle of the present invention where self-excited vibration is caused when the conductors of the electrical equipment are in an AC voltage mode.
Figure 4 is a waveform diagram for explaining the frequency of the self-excited vibration when the conductors of the electrical equipment are in the AC voltage mode.
Figure 5 is a diagram showing vibration spectrum detected by the vibration detector of the present invention when the conductors of the electrical equipment are in the AC voltage mode.
Figure 6 is a diagram showing vibration spectrum detected by the vibration detector of the present invention when the conductors of the electrical equipment are in a DC voltage mode.
Figure 7 is a schematic diagram for explaining the principle of the present invention where self-excited vibration is caused when the conductors of the electrical equipment are in an AC current mode.
Figure 8 is a waveform diagram for explaining the frequency of the self-excited vibration when the conductors of the electrical equipment are in the AC current mode.
Figure 9 is a diagram showing vibration spectrum detected by the vibration detector of the present invention when the conductors of the electrical equipment are in the AC current mode.
Figure 10 is an outside view of the apparatus for detecting voltage and current status associated with the second embodiment of the present invention.
Figure 11 is a schematic diagram showing vibration spectrum indicating an amplitude (absolute value) of each angular frequency (absolute value) when irradiating an electromagnetic wave on the conductors of the electrical equipment provided with an AC voltage to cause a forced vibration.
Figure 12 is a schematic diagram showing vibration spectrum indicating an amplitude (absolute value) of each angular frequency (absolute value) when irradiating an electromagnetic wave on the conductors of the electrical equipment provided with a DC voltage to cause a forced vibration.
Figure 13 is a schematic diagram showing vibration spectrum indicating an amplitude (absolute value) of each angular frequency (absolute value) when irradiating an electromagnetic wave on the conductors of the electrical equipment provided with a DC current to cause a forced vibration.
Figure 14 is an outside view of the apparatus for detecting voltage and current status associated with the third embodiment of the present invention.
Figure 15 is an example of outside view of the apparatus for detecting voltage and current status of the present invention structured in a portable body.

DETAILED DESCRIPTION OF THE INVENTION

The present invention will be described in detail with reference to the accompanying drawings. It should be noted that within the context of the present invention, a status of conductors of the electrical equipment where a high voltage is applied thereto but current is not flowing is defined as a "voltage mode" and a status of the conductors where a high voltage is applied thereto and current is flowing is defined as a "current mode".

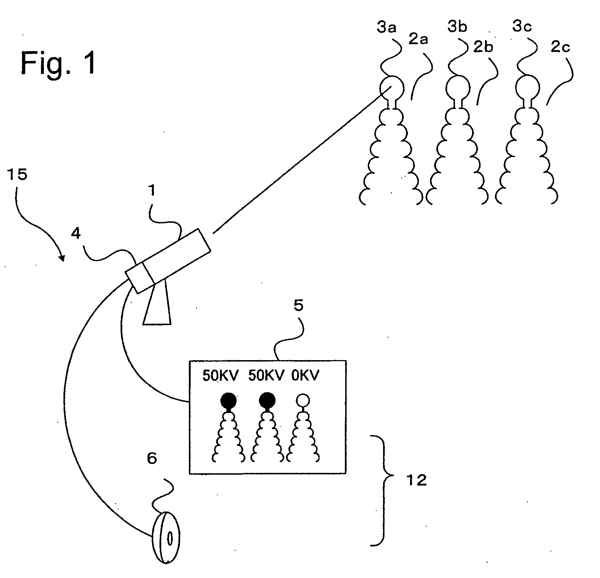

Figure 1 is an outside view of the apparatus for detecting voltage and current status (voltage and current mode detection apparatus) associated with the first embodiment of the present invention. Figure 1 shows a manner of detecting a voltage mode on conductors 3a-3c of electrical equipment 2a-2c by the voltage and current mode detection apparatus 15 of the present invention. In the voltage mode, the conductors 3a-3c of the electrical equipment 2a-2c vibrate in a small degree in response to the applied voltage. The principle of operation as to how the self-excited vibration is occurred will be explained later.

The voltage and current mode detection apparatus 15 includes a vibration detector 1, a processor 4, and an output device 12 including a display 5 and a speaker 6. The vibration detector 1 detects the self-excited vibration of the conductors 3a-3c of the electrical equipment 2a-2c. For doing this, the vibration detector 1 irradiates a wave on the conductors 3a-3c of the electrical equipment 2a-2c, and based on the frequencies of the incident wave and reflected wave, it detects a vibration on the conductors 3a-3c.

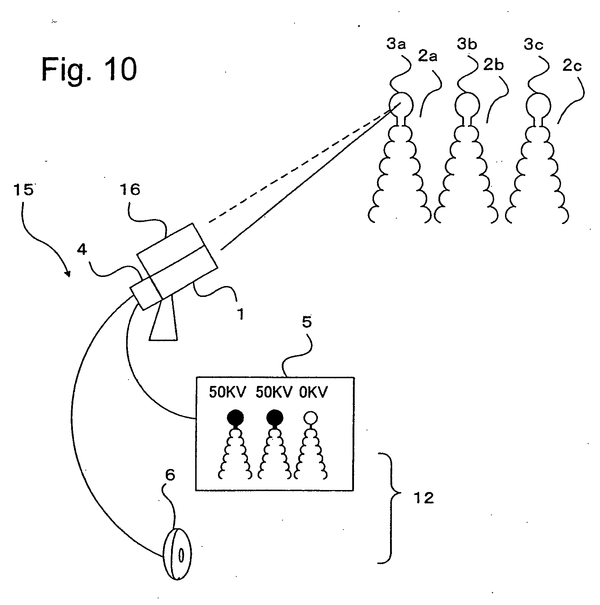

As for the wave generated by the vibration detector 1 to detect the vibration of conductors 3a-3c of electrical equipment 2a-2c, a laser beam, for example, is used. Alteratively, other electromagnetic wave generated by an electromagnetic wave generator 16 (Figure 10) can be used. Suppose a frequency of the laser beam incident to the conductors and a frequency of the laser beam reflected from the conductors are denoted by S1 and S2, respectively, the frequencies S1 and S2 can be expressed by equations (1) and (2) as follows:

$$S1 = v_1/\lambda \tag{1}$$

$$S2 = v_1/\lambda + 2v_2/\lambda \tag{2}$$

where $v_1$ is a velocity of the laser beam, $v_2$ is a velocity of the self-excited vibration of the conductors, and $\lambda$ is a wavelength of the laser beam.

The vibration detector 1, as shown in equation (3) below, calculates the difference between the incident beam frequency S1 and the reflected beam frequency S2 to detect a vibration frequency S of the conductors 3a-3c of the electrical equipment 2a-2c:

$$S = S2 - S1$$

$$= 2v_2/\lambda$$

The vibration detector 1 is connected to the processor 4, where the vibration of conductors 3a-3c of the electrical equipment 2a-2c detected by the vibration detector 1 is processed. When the conductors 3a-3c are in the voltage mode, the information indicating the voltage mode will be provided to the display 5 and the speaker 6 in the output unit 12.

Figure 1 shows a situation where the conductors 3a and 3b of the electrical equipment 2a and 2b are in the voltage mode with a voltage of 50kV. Accordingly, the conductors 3a and 3b in the voltage mode are displayed on the display 5 of output unit 12 by using, for example, a predetermined color with a numerical value showing the voltage.

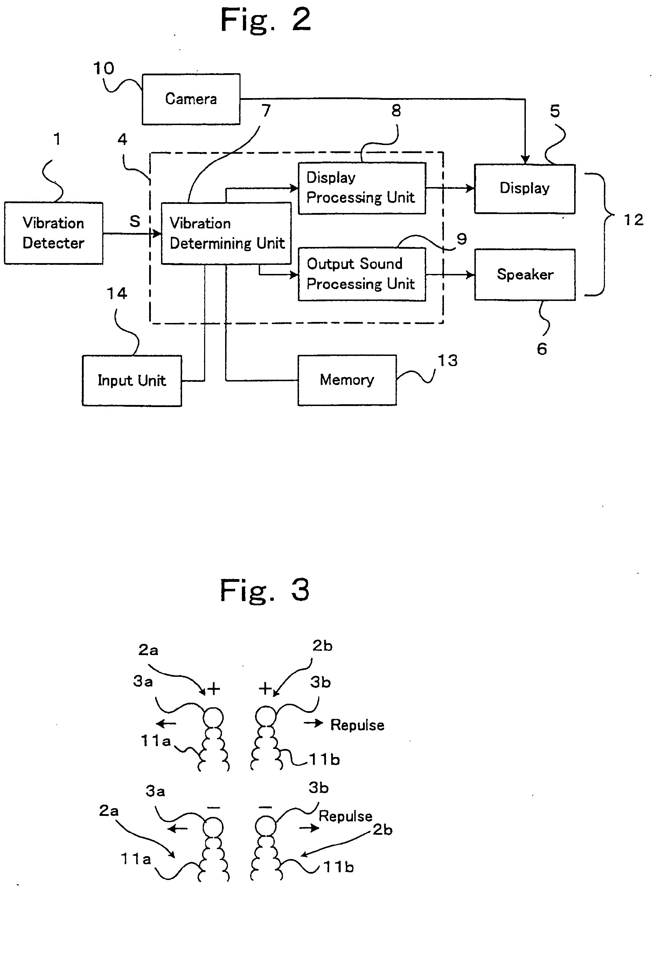

Figure 2 is a block diagram of the processor 4 in the vibration detector 1. The processor 4 includes a vibration determining unit 7, a display processing unit 8, and an output sound processing unit 9. The reflected signal carrying the information on the vibration of the conductors 3a-3c of the electrical equipment 2a-2c detected by vibration detector 1 is provided to the vibration determining unit 7. The vibration determining unit 7 determines whether an amplitude of the frequency S detected by the vibration detector 1 exceeds a predetermined threshold value. If it does exceed the predetermined threshold value, the vibration determining unit 7 determines that the conductors 3a-3c of the electrical equipment 2a-2c are in the voltage mode.

For this purpose of detecting the voltage mode, only one threshold value is sufficient. However, for a user to instinctively know the amount of voltage in the voltage mode through a visual sense, several predetermined threshold values may be preferably used. This can determine the range to which the detected vibration amplitude belongs.

Thus, in the case where only one predetermined threshold value is used, the vibration determining unit 7 outputs "0" when the amplitude does not exceed the threshold value, and outputs "1" when it does exceed the predetermined value. Further, in the case of using several predetermined values, the vibration determining unit 7 outputs "0" when the amplitude does not exceed any of the predetermined values, outputs "1" when it does exceed the first predetermined value but not the second, outputs "2" when it does exceed the second predetermined value but not the third, and similarly, outputs "n" when it does exceed the $n^{th}$ predetermined value but not the (n+1)th value.

The display processing unit 8 selects predetermined colors in response to the output signal from the vibration determining unit 7, and displays the output on the display 5 of the output unit 12. For example, in the case of having one predetermined value, white is displayed when the output is "0", and red is displayed when the output is "1". This means that the red is displayed when the test target is either in the voltage mode or the current mode.

In the case of having several predetermined values such as three, white will be used when the output is "0", yellow will be used when the output is "1", orange will be used when the output is "2", and red will be displayed when the output is "3". This means that different colors are displayed in response to the amplitude of vibration in the voltage mode or current mode.

When displaying the value of the voltage numerically, the information specifying the conductors 3a-3c of the electrical equipment 2a-2c from an input unit 14 is provided in advance to the vibration determining unit 7 of the processor 4. The amplitude of the detected signal is proportional to the voltage in the voltage mode as well as an electrical field of the electromagnetic wave irradiated from an electromagnetic wave generator 16 (Figure 10). However, the value of the voltage in the voltage mode changes depending on a distance between the conductors 3a-3c or a shape, weight, and individual frequency of the conductors 3a-3c, thus, the information concerning the conductors have to be provided in advance.

In other words, since the correlation between the amplitude of the detected vibration and the voltage value in the voltage mode is different for each of the conductors 3a-3c, such information regarding the correlation for each conductor is stored in a memory 13 of the processor 4 in advance. Then, upon receiving the amplitude of the detected signal, the vibration determining unit 7 in the processor 4 extracts the correlation information from the memory 13, converts the amplitude into a voltage value based on the correlation, and provides the voltage value to the display 5 through the display processing unit 8. Consequently, the voltage mode of the conductors 3a-3c will be displayed in color, and the voltage value of the voltage mode will be displayed numerically. Although this example utilizes both the color and numbers on the display, only one of them can be used on the displayed.

Next, the output sound processing unit 9 selects a predetermined sound message in response to the output signal from the vibration determining unit 7, and supplies the selected sound message to the speaker 6 in the output unit 12. For example, in the case where one predetermined threshold value is used as noted above, no sound is supplied when the output is "0", and a loud sound is supplied when the output is "1". Thus, the loud sound will be generated when the conductors 3a-3c are in the voltage mode.

On the other hand, in the case where several threshold values such as three are used, it can be arranged that no sound is supplied to the speaker 6 when the output of the vibration determining unit 7 is "0", a small sound is supplied to the speaker 6 when the output is "1", an average sound is supplied when the output is "2", and a loud sound is supplied when the output is "3". Thus, different levels of sound will be generated in response to the vibration amplitude of the voltage mode of the conductors 3a-3c.

Here, when the laser beam from the vibration detector 1 irradiated on the conductors 3a-3c moves either up and down or right and left, and the conductors 3a-3c vibrate, the shapes of the conductors 3a-3c can be known. However, it is not possible to know the shapes of the conductors 3a-3b when not vibrating.

Therefore, a camera 10 is incorporated in the voltage and current mode detection apparatus 15 to film the images of electrical equipment 2a-2c and display the images on the display 5. Then, the color corresponding to the amplitude is added to the vibrating part of the electrical equipment 2a-2c displayed on the display 5 by the display processing unit 8. This allows the workers to instinctively grasp the status, i.e., the voltage mode, of the conductors 3a-3c of the electrical equipment 2a-2c.

The foregoing description is made for the case for detecting the voltage mode of the conductors 3a-3c of the electrical equipment 2a-2c by the voltage and current mode detection apparatus 15 of the present invention. In a similar fashion, the current mode of the conductors 3a-3c can also be detected, since the conductors 3a-3c of the electrical equipment 2a-2c in the current mode vibrates slightly. The principle of the self-excited vibration arising in the conductors 3a-3c of the electrical equipment 2a-2c in the current mode will be explained later.

Here, the voltage and current mode detection apparatus 15 determines whether the conductors 3a and 3b of the electrical equipment 2a and 2b are vibrating or not in either voltage or current mode. However, it is not possible to specify which mode the conductors 3a and 3b are actually in by simply monitoring the vibration. Therefore, the distinction of whether the conductors 3a and 3b of the electrical equipment 2a and 2b are in the voltage mode or the current mode will be done by specifying the electrical equipment in advance.

For example, in the electrical power system, there exists a conductor 3 which is provided with a voltage (voltage mode) but no current flows therethrough under an active state. For example, an arcing-horn established as a shielding ring to prevent corona discharge or as a current path during an accident is in the voltage mode. In contrast, a power cable is flowing current (current mode) under an active state.

Thus, by storing the information regarding whether the voltage or current mode per every electrical equipment in the memory 13 and inputting the information specifying the target electrical equipment through an input unit 14 (Figure 2) to the processor 4 prior to the test, the voltage mode or current mode can be identified. As a consequence, the voltage value will be displayed on the display 5 when the electrical equipment is in the voltage mode, and the current value will be displayed on the display 5 when the electrical equipment is in the current mode.

The principle of self-excited vibration of the conductors in the voltage mode will be explained in the following. Figure 3 is a diagram for explaining the principle where the self-excited vibration is caused when the conductors are in the voltage mode when AC voltage is provided thereto (AC voltage mode). In this example, the electrical equipment 2a and 2b are configured by the conductors 3a and 3b which are provided on corresponding insulators 11a and 11b. It is also assumed that a single phase AC voltage is applied to the conductors 3a and 3b. When such electrical equipment 2a and 2b are positioned in parallel with each other where the AC voltage of the same phase is applied to the conductors 3a and 3b, repulsion is produced when the voltage polarity is either positive or negative. This repulsion is proportional to the square root of the applied voltage.

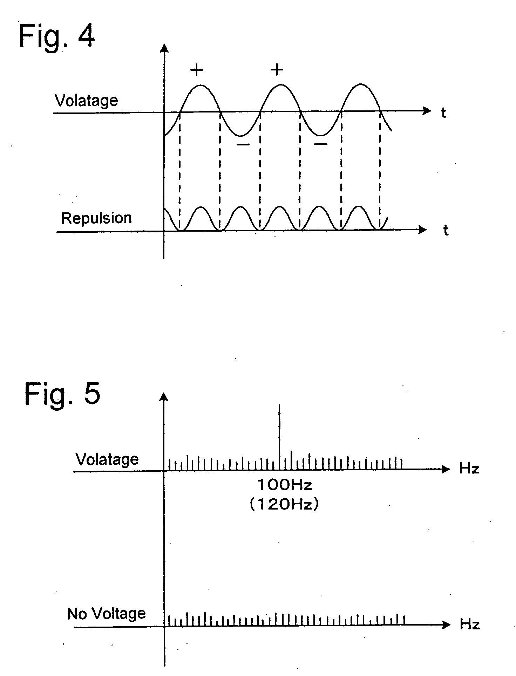

Figure 4 shows waveforms for explaining the vibration frequency produced on the conductors 3a and 3b of the electrical equipment 2a and 2b in the AC voltage mode. As noted above, the repulsion of the conductors 3a and 3b is proportional to the square root of the voltage applied, and is generated during both positive and negative polarities of the AC voltage. Consequently, an amplitude of the vibration is proportional to the square root of the AC voltage, and the vibration frequency is twice the frequency of the AC voltage applied to the conductors 3a and 3b.

When denoting a force acted on the conductors 3a and 3b as $F_1$, an electric charge charged in the conductors 3a and 3b as Q, an electrical field surrounding the conductors 3a and 3b as E, and an AC voltage applied to the conductors 3a and 3b as $V_m\cos\omega_1 t$, the following equations (4)-(7) are formed:

$$F_1 = Q \cdot E \tag{4}$$

$$Q \propto V_m\cos\omega_1 t \tag{5}$$

$$E \propto V_m\cos\omega_1 t \tag{6}$$

$$
\begin{aligned}
F_1 \ \propto \ (V_m\cos\omega_1 t)^2 \ &= \ V_m^2\cos^2\omega_1 t \\
&= \ (V_m^2/2) \ \bullet \ (1 + \cos 2\omega_1 t) \\
&= \ (V_m^2/2) \ \bullet \ \cos 2\omega_1 t \ + \ (V_m^2/2) \qquad \dots (7)
\end{aligned}
$$

As shown in equation (7), since the force $F_1$ changing at angular frequency $2\omega_1$ is acted on the conductors 3a and 3b of the electrical equipment 2a and 2b, a vibration of this angular frequency $2\omega_1$ is generated. Thus, when a frequency $f_1$ ($\omega_1 = 2\pi f_1$) of the AC voltage applied to the electrical equipment 2a and 2b is a commercial frequency of 50Hz or 60Hz, the angular frequency $2\omega_1$ of the vibration is twice of the commercial frequency, i.e., 100Hz or 120Hz. This means that the vibration detector 1 will detect this frequency and the vibration amplitude of the conductors 3a and 3b of the electrical equipment 2a and 2b in the voltage mode.

Figure 5 shows the vibration spectrum detected by the vibration detector 1 when the conductors 3a and 3b of the electrical equipment 2a and 2b are in the AC voltage mode. When the AC voltage of commercial frequency (50Hz or 60Hz) is applied to the conductors 3a and 3b, a large vibration amplitude is observed at the frequency (100Hz or 120Hz) two times of the commercial frequency as shown in the upper part of Figure 5. On the other hand, when the AC voltage is not applied, there may be small and random vibrations in a wide range of frequency bandwidth, however, the vibration caused by the voltage mode will not be observed as shown in the lower part of Figure 5. The vibrations detected when the AC voltage is not applied are random vibrations caused by the environment surrounding the conductors 3a and 3b, such as vibrations by vehicle and people movements, vibrations by various electrical and mechanical facilities and devices, and vibrations by the wind.

Therefore, the vibration determining unit 7 in the processor 4 detects the vibration signal with the specified frequency, i.e., twice the commercial frequency (100Hz or 120Hz) in the above example, and compares the amplitude of the vibration with a predetermined value to determine whether the conductors 3a-3c are in the voltage mode or not.

The above explanation is made for the case of the AC voltage mode. Since similar vibration is also generated in the DC voltage mode as well, the voltage and current mode detection apparatus of the present invention can detect that the conductors 3a-3b are in the voltage mode.

Here, the principle of the self-excited vibration of the conductor 3 of electrical equipment 2 in the DC voltage mode will be explained. When the conductor 3 of electrical equipment 2 is in the DC voltage mode, the molecules and particulates in the air near the conductor 3 are charged. By Coulumb forces acted between polarities of the conductor receiving the DC voltage and polarities of the charged molecules and particulates, attraction and repulsion actions are exerted therebetween. Because of the attraction and repulsion actions, a vibration is excited on the conductor 3 of the electrical equipment 2.

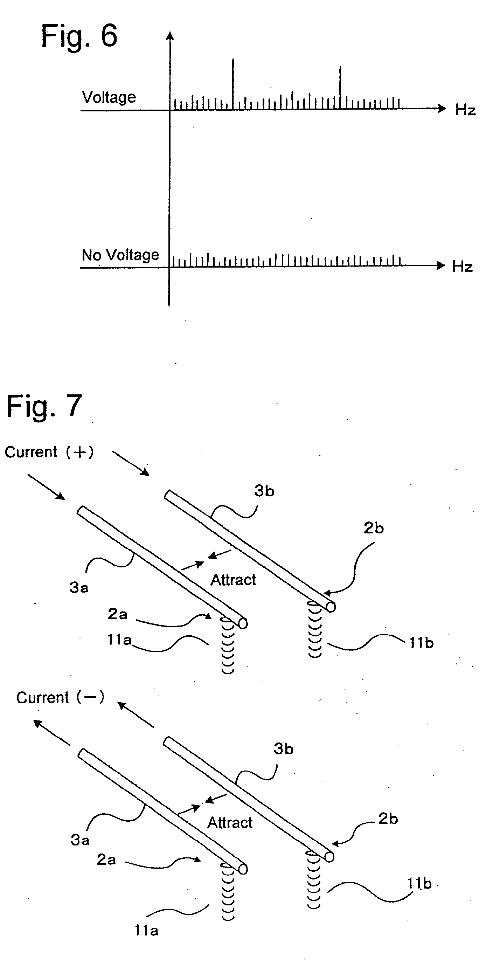

Figure 6 shows the vibration spectrum detected by the vibration detector 1 when the conductor 3 of the electrical equipment 2 is in the DC voltage mode. In the DC voltage mode, vibrations different from the random vibrations caused by the surrounding environment, such as wind, can be observed as shown in the upper part of Figure 6. The frequency of the self-excited vibration in the DC voltage mode is not a specific value as in the AC voltage mode (ex. two times of the applied AC voltage frequency). However, the vibration frequency which is not caused by the wind or surrounding environment will be generated. Therefore, the voltage mode can still be detected even in the DC voltage mode.

Here, the principle of the self-excited vibration of the conductor 3 of the electrical equipment 2 in the current mode is explained with reference to Figure 7 which shows a case where an alternating current (AC) flows in the conductors 3a and 3b (AC current mode). In this example, the electrical equipment 2a and 2b are configured by the conductors 3a and 3b provided on the corresponding insulators 11a and 11b, respectively. The AC current of single phase (identical phase) flows through the conductors 3a and 3b. When such electrical equipment 2a and 2b are positioned in parallel with each other, where the alternating current in the conductors 3a and 3b have the same phase, an attraction force is produced whether the voltage polarity is either positive or negative. The attraction force is proportional to the square root of the alternating current.

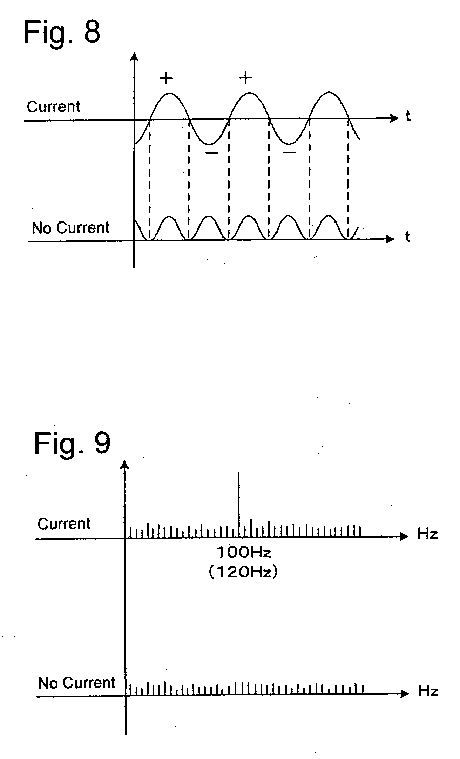

Figure 8 shows waveforms for explaining the vibration frequency produced on the conductors 3a and 3b of the electrical equipment 2a and 2b in the alternating current mode. As noted above, the attraction force between the conductors 3a and 3b is proportional to the square root of the alternating current and acted either in the positive or negative polarity. Consequently, the amplitude of the vibration is proportional to the square root of the alternating current, and the vibration frequency is twice as the frequency of the alternating current flowing in the conductors 3a and 3b.

By denoting a force acted between the conductors 3a and 3b as $F_1$, a magnetic density on the surface of the conductor 3 as B, and a current flowing through the conductor 3 as $I_m \cos \omega_1 t$, the following equations (8)-(10) are formed:

$$F_1 = B \cdot I_m \cos \omega_1 t \qquad (8)$$

$$B \propto I_m \cos \omega_1 t \qquad (9)$$

$$\begin{aligned}
F_1 \propto (I_m \cos \omega_1 t)^2 &= I_m^2 \cos^2 \omega_1 t \\
&= (I_m^2/2) \cdot (1 + \cos 2\omega_1 t) \\
&= (I_m^2/2) \cdot \cos 2\omega_1 t + (I_m^2/2) \qquad \cdots (10)
\end{aligned}$$

As shown in equation (10), since the force $F_1$ changing at angular frequency $2\omega_1$ is acted on the conductors 3a and 3b of the electrical equipment 2a and 2b, a vibration with this angular frequency $2\omega_1$ is generated. When the frequency $f_1$ ($\omega_1 = 2\pi f_1$) of the alternating current in the electrical equipment 2a and 2b has a commercial frequency of 50Hz or 60Hz, the angular frequency $2\omega_1$ becomes twice of the commercial frequency, i.e., 100Hz or 120Hz. This means that the vibration detector 1 will detect this frequency and the vibration amplitude of the conductors 3a and 3b of the electrical equipment 2a and 2b in the current mode.

Figure 9 shows the vibration spectrum detected by the vibration detector 1 when the conductors 3a and 3b of the electrical equipment 2a and 2b are in the AC current mode. When the alternating current of the commercial frequency (50Hz or 60Hz) is flowing through the conductors 3a and 3b, a large vibration amplitude with a frequency two times of the commercial frequency (100Hz or 120Hz) is observed as shown in the upper part of Figure 9. On the other hand, when the alternating current is not flowing, there may be small and random vibrations in a wide range of frequency bandwidth, however, the vibration caused by the current mode will not be observed as shown in the lower part of Figure 9. The vibrations detected when the alternating current is not flowing are random vibrations caused by the surrounding environment of the conductors 3a and 3b, such as vibrations by vehicle and people movements, vibrations by various electrical and mechanical facilities and devices, and vibrations by the wind.

Therefore, the vibration determining unit 7 in the processor 4 detects the vibration signal with the specified frequency, i.e., twice the commercial frequency (100Hz or 120Hz) in the above example, and compares the amplitude of the vibration with a predetermined value to determine whether the conductors 3a-3c are in the current mode or not.

According to the embodiment of the present invention described above, the vibration detector 1 detects very small vibrations to determine whether the conductors 3a-3c of the electrical equipment 2a-2c are either in the voltage mode or current mode. When the amplitude of the specific frequency of the vibration detected by vibration detector 1 exceeds the predetermined value, the conductors 3a-3c of the electrical equipment 2a-2c are determined to be either in the voltage mode or current mode. Then, the result is provided to the display 5 in the output unit 12 to be displayed, thereby visually expressing the existence of the electricity on the conductors 3a-3c.

Another embodiment of the present invention will be explained. Figure 10 is an outside view of the voltage and current mode detection apparatus associated with the second embodiment of the present invention. Unlike the first embodiment shown in Figure 1, the voltage and current mode detection apparatus 15 in Figure 10 includes an electromagnetic wave generator 16. The electromagnetic wave generator 16 irradiates an electromagnetic wave of a selected frequency on the conductors 3a-3c of the electrical equipment 2a-2c to produce a forced vibration on the conductors 3a-3c in the voltage mode. This means that the vibration detector 1 will detect the self-excited vibration of the conductors 3a-3c in the voltage mode as well as the forced vibration of the conductors 3a-3c of the electrical equipment 2a-2c produced by the electromagnetic wave from the electromagnetic wave generator 16.

Namely, Figure 10 shows a situation where the electromagnetic wave irradiated by the electromagnetic wave generator 16 causes the forced vibration on the conductors 3a-3c of the electrical equipment 2a-2c which are provided with the AC voltage (AC voltage mode) and detects the forced vibration by the voltage and current mode detection apparatus 15. The same elements as in the embodiment of Figure 1 are denoted by the same reference numbers, and the duplicated explanations will be abbreviated.

The principle of the forced vibration of the conductors 3a-3c of the electrical equipment 2a-2c in the AC voltage mode upon irradiating the electromagnetic wave from the electromagnetic wave generator 16 will be explained. An electromagnetic wave with an electrical field of $E_m \cos\omega_2 t$ is irradiated on the conductors 3a and 3b are provided with the AC voltage $V_m \cos\omega_1 t$. In this situation, a force $F_2$ acted on the conductors 3a and 3b is expressed by equation (11) below based on the equations (4) and (5):

$$
\begin{aligned}
F_2 &= Q \bullet E \\
&\propto V_m \cos\omega_1 t \bullet E_m \cos\omega_2 t \\
&= (V_m \bullet E_m/2)\{\cos(\omega_1 + \omega_2)t + \cos(\omega_1 - \omega_2)t\} \qquad \text{...(11)}
\end{aligned}
$$

As shown in equation (11), the amplitude of the force $F_2$ is proportional to $(V_m \bullet E_m/2)$, and two different vibrations with angular frequencies of $(\omega_1 + \omega_2)$ and $(\omega_1 - \omega_2)$ are generated by the electromagnetic wave irradiated from the electromagnetic wave generator 16. By denoting the first member of equation (11) as $F_{21}$ and the second member as $F_{22}$, the force that generates a vibration in the electrical equipment 2a and 2b is expressed by equations (12), (13), and (14) below. Equation (12) is the same as equation (7), which shows a self-excited vibration in the AC voltage mode. The reference numbers $F_1$, $F_{21}$, and $F_{22}$ indicate forces, however, they will be denoted as vibrations $F_1$, $F_{21}$, and $F_{22}$ for convenience of explanation.

$$F_1 \propto (V_m^2/2) \bullet \cos2\omega_1 t + (V_m^2/2) \tag{12}$$

$$F_{21} \propto (V_m \bullet E_m/2)\cos(\omega_1 + \omega_2)t \tag{13}$$

$$F_{22} \propto (V_m \bullet E_m/2)\cos(\omega_1 - \omega_2)t \tag{14}$$

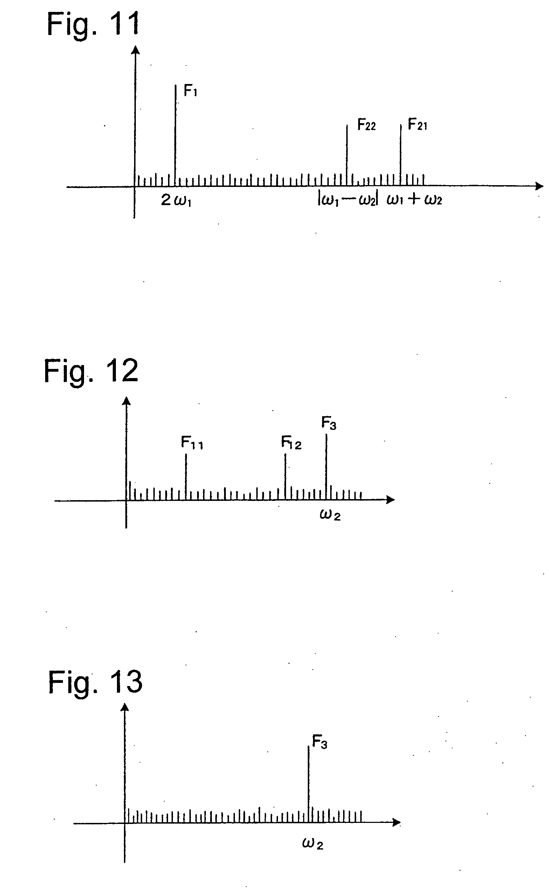

Figure 11 shows the vibration spectrum where the amplitude (absolute value) of each angular frequency (absolute value) is expressed in the frequency domain when the electromagnetic wave is irradiated on the conductors 3a and 3b of the electrical equipment 2a and 2b to generate the forced vibration. The self-excited vibration is observed which has an angular frequency $2\omega_1$ expressed by the equation (12). In other words, when the frequency $f_1$ ($\omega_1 = 2\pi f_1$) of the AC voltage applied to the electrical equipment 2a and 2b is the commercial frequency of 50Hz or 60Hz, the angular frequency $2\omega_1$ is twice of the commercial frequency, i.e., 100Hz or 120Hz. The amplitude of the self-excited vibration at the angular frequency $2\omega_1$ is proportional to ($V_m^2/2$). This means that vibration detector 1 will detect this frequency and amplitude of the conductors 3a and 3b of the electrical equipment 2a and 2b in the voltage mode. The second member of equation (12) will not be considered since only the detection of the vibration is essential.

In the second embodiment, in addition to the self-excited vibration, the vibrations $F_{21}$ and $F_{22}$ caused by the angular frequency $\omega_2$ of the electromagnetic wave are generated. As shown in equations (13) and (14), the amplitude of the vibration $F_{21}$ is proportional to $V_m \cdot E_m/2$ at the angular frequency ($\omega_1 + \omega_2$), and the amplitude of the vibration $F_{22}$ is proportional to $V_m \cdot E_m/2$ at the angular frequency $|\omega_1 - \omega_2|$.

The frequency of the electromagnetic wave from the electromagnetic wave generator 16 is selected to a frequency significantly higher than the frequency of the voltage or current applied to the conductor 3, such as higher than 1,000Hz. For example, the angular frequency $\omega_2$ of the electromagnetic wave is in the range more than three times higher than the angular frequency $\omega_1$, i.e., $\omega_2 > 3\omega_1$. Thus, the angular frequency ($\omega_1 + \omega_2$) of the vibration $F_{21}$ and the angular frequency $|\omega_1 - \omega_2|$ of the vibration $F_{22}$ become much higher than $2\omega_1$ as shown in Figure 11.

Accordingly, by selecting a frequency range where no communication waves are used as the angular frequency ($\omega_1 + \omega_2$) of vibration $F_{21}$ and the angular frequency $|\omega_1 - \omega_2|$ of vibration $F_{22}$, the vibration can be detected under a condition with less noise, i.e., higher sensitivity. As a result, the vibration of the conductors 3a-3c can be detected properly by the vibration detector 1 even when the value of the AC voltage is small.

Next, the principle of the forced vibration of the conductors 3a-3c which is provided with the DC voltage upon irradiating the electromagnetic wave by the electromagnetic wave generator 16 will be explained. For the conductor 3 provided with a DC voltage $V_m$, an electromagnetic wave with an electrical field of $E_m\cos\omega_2 t$ is irradiated. Since the charge Q in the conductor 3 with the DC voltage $V_m$ is proportional to the DC voltage $V_m$, a force $F_3$ acted on the conductor 3 is expressed by equation (15) based on the equation (4):

$$F_3 = Q \cdot E$$

$$\propto V_m \cdot E_m\cos\omega_2 t \qquad\qquad (15)$$

As shown in equation (15), by the electromagnetic wave irradiated from the electromagnetic wave generator 16, the vibration with the amplitude proportional to $V_m \cdot E_m$, and the angular frequency $\omega_2$ is generated on the conductor 3. This means that vibration detector 1 will detect the amplitude and the vibration frequency of the conductor in the DC voltage mode.

Figure 12 shows the vibration spectrum of conductors 3a and 3b in the DC voltage mode when the electromagnetic wave of the angular frequency $\omega_2$ is irradiated by the electromagnetic wave generator 16. The vibrations $F_{11}$ and $F_{12}$ are self-excited vibrations based on the DC voltage $V_m$ applied to the conductors 3a and 3b. The angular frequency of the self-excited vibrations will change by the change in the surrounding conditions and are not specified unlike the frequency under the AC voltage mode (twice the of the AC voltage applied). The vibration $F_3$ is produced by the electromagnetic wave from the electromagnetic wave generator 16, with the angular frequency $\omega_2$ identical to that of the electromagnetic wave.

Under the relationship shown in Figure 12, by selecting a frequency range for the angular frequency $\omega_2$ where no communication waves are used, the vibration of the conductors 3a and 3b can be detected with less noise and high sensitivity. Further, by changing the electrical field $E_m$ of the electromagnetic wave irradiating on the conductors 3a and 3b, the amplitude of the vibration can be controlled to an optimum value. Consequently, the DC voltage mode can be detected accurately by the vibration detector 1 of the present invention.

The foregoing description is made for the case where the forced vibration is produced for the conductors in the AC voltage mode or DC voltage mode. The same relationship is also applicable to the conductors in the current mode where an electromagnetic wave from the electromagnetic wave generator 16 produces a forced vibration on the conductors flowing electric current.

Here, the principle of the forced vibration of the conductors flowing the alternating current (AC current mode) upon irradiating an electromagnetic wave from the electromagnetic wave generator 16 will be explained. It is assumed that an electromagnetic wave with magnetic field $H_m\cos\omega_2 t$ is irradiated on the conductors 3a and 3b where an alternating current $I_m\cos\omega_1 t$ flows therethrough. When magnetic permeability is denoted by $\mu$, magnetic flux density denoted by B on the surface of the conductor 3 is expressed by equation (16):

$$B = \mu H_m \cos\omega_2 t \tag{16}$$

Therefore, a force $F_2$ acted on the conductors 3a and 3b is expressed by equation (17) below based on equations (8), (9), and (16):

$$F_2 = B \cdot I_m \cos\omega_1 t$$

$$\propto H_m \cos\omega_2 t \cdot I_m \cos\omega_1 t$$

$$= (I_m \cdot H_m/2)\{\cos(\omega_1 + \omega_2)t + \cos(\omega_1 - \omega_2)t\} \tag{17}$$

As shown in equation (17), the amplitude of the vibration is proportional to $(I_m \cdot H_m/2)$, and two different vibrations with angular frequencies of $(\omega_1 + \omega_2)$ and $(\omega_1 - \omega_2)$ are generated by the electromagnetic wave irradiated from the electromagnetic wave generator 16. By denoting the first member of equation (17) as $F_{21}$ and the second member as $F_{22}$, the force that generates a vibration in the electrical equipment 2a and 2b is expressed by equations (18), (19), and (20) below. Equation (18) is the same as equation (10), which shows a self-excited vibration when an alternating current is flowing (AC current mode).

$$F_1 \propto (I_m{}^2/2) \cdot \cos 2\omega_1 t + (Im^2/2) \tag{18}$$

$$F_{21} \propto (I_m \cdot H_m/2)\cos(\omega_1 + \omega_2)t \tag{19}$$

$$F_{22} \propto (I_m \cdot H_m/2)\cos(\omega_1 - \omega_2)t \tag{20}$$

These equations (18)-(20) correspond to equations (12)-(14), except that the voltage $V_m$ and electrical field $E_m$ are replaced with the current $I_m$ and magnetic field $H_m$, respectively. Thus, the vibration spectrum of each angular frequency also has similar characteristics as shown in Figure 4. Accordingly, similar to the AC voltage mode, it is possible to determine whether the conductor 3 is in the AC current mode or not.

Next, the principle of the forced vibration of the conductors which flow a direct current (DC current mode) upon irradiating an electromagnetic wave by the electromagnetic wave generator 16 will be explained. When a force acted on the conductors 3a and 3b of the electrical equipment 2a and 2b where the direct current $I_m$ is flowing is denoted as $F_1$, and magnetic flux density on the surface of conductors 3a and 3b is denoted as B, the following equations (21) - (23) are formed:

$$F_1 = B \cdot I_m \tag{21}$$

$$B \propto I_m \tag{22}$$

$$F_1 \propto I_m{}^2 \tag{23}$$

The force $F_1$ acted on the conductors 3a and 3b produces an attraction force when the direct currents of the same polarity flow therethrough, and a repulsion force when the direct currents of the opposite polarities exists flow therethrough. However, since the force $F_1$ acted on the conductors 3a and 3b will not change over the time, vibration of the conductors 3a and 3b by the direct current $I_m$ will not occur.

Therefore, a vibration is forcefully produced for the conductors in the DC current mode upon irradiating an electromagnetic wave from the electromagnetic wave generator 16. Here, an electromagnetic wave with magnetic field $H_m\cos\omega_2 t$ is irradiated on the conductors 3a and 3b flowing the direct current $I_m$. In this case, since the magnetic flux density B on the surface of conductors 3a and 3b which changes over time is expressed by equation (16), a force $F_3$ acted on the conductors 3a and 3b, which also changes over time, is expressed by equation (24) below:

$$F_3 = B \cdot I_m$$

$$\propto I_m \cdot H_m \cos\omega_2 t \qquad\qquad (24)$$

As shown in equation (24), the amplitude of the vibration is proportional to $I_m \cdot H_m$, and the angular frequency of the vibration $\omega_2$ is identical to that of the electromagnetic wave irradiated by electromagnetic wave generator 16. This means that the vibration detector 1 will detect the frequency and amplitude of the forced vibration of the conductor in the current mode. This equation (24) corresponds to equation (15) in the DC voltage mode except that the voltage $V_m$ and electrical field $E_m$ are replaced with the current $I_m$ and magnetic field $H_m$, respectively.

Figure 13 shows the vibration spectrum of the conductors 3a and 3b when the electromagnetic wave of angular frequency $\omega_2$ is irradiated from the electromagnetic wave generator 16. The vibration $F_3$ is a forced vibration acted on the conductors 3a and 3b by the electromagnetic wave, and its amplitude, as shown in equation (24), is proportional to $I_m \cdot H_m$, where the angular frequency is $\omega_2$. By selecting the angular frequency $\omega_2$ of the electromagnetic wave in a range with no communication waves, the vibration of the conductors 3a and 3b can be detected in a range with less noise, i.e., high sensitivity. Further, by changing the magnetic field $H_m$ of the irradiated electromagnetic wave, the amplitude of the vibration can be adjusted to a proper level. As a result, the vibration detector 1 can properly and accurately detect the DC voltage mode of the conductors 3a and 3b.

According to the embodiment described above, when the conductors 3a and 3b of the electrical equipment 2a and 2b are in either the voltage or current mode upon irradiating an electromagnetic wave the from the electromagnetic wave generator 16, a forced vibration is generated. Thus, even when the electrical equipment is in the DC current mode where no self-excited vibration occurs, the DC current mode can be detected. Further, by changing the frequency of the irradiated electromagnetic wave, the frequency of the forced vibration can also be changed. Therefore, by selecting the frequency in a range with no communication waves, the DC current mode can be detected with less noise and high sensitivity.

In the above explanation, the vibration detector 1 measures the vibration frequency of the target conductors by the difference between the frequency of the incident waves and reflected waves using a laser beam. However, any wave capable of obtaining a doppler effect can be used in place of the laser beam.

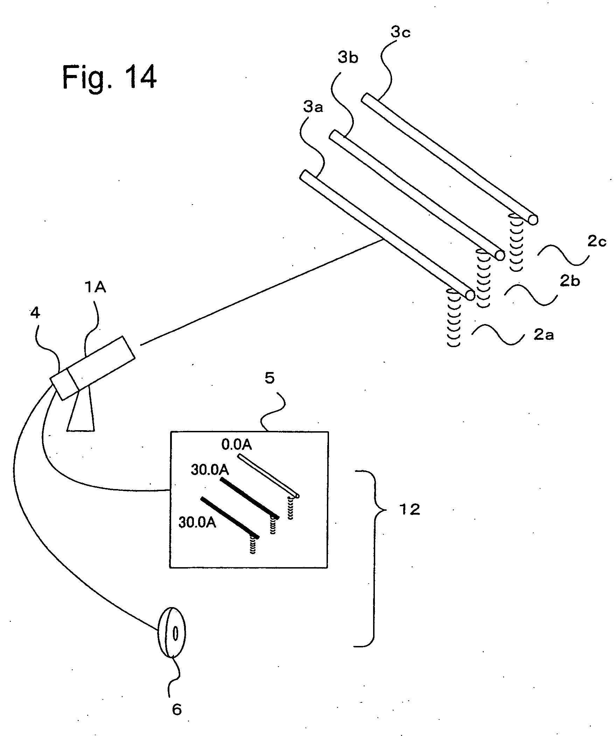

Next, a further embodiment of the present invention will be explained. Figure 14 is an outside view of the voltage and current mode detection apparatus associated with the third embodiment of the present invention. This embodiment uses the electromagnetic wave for forcefully generating a vibration of the conductors 3a and 3b of the electrical equipment 2a and 2b as well as for detecting the vibration. Namely, the electromagnetic wave is utilized both to detect and generate a vibration on the conductors 3a-3c of the electrical equipment 2a-2c. The electromagnetic wave is generated by a vibration detector 1A. Figure 14 shows a situation to detect the current mode of the conductors 3a-3c of the electrical equipment 2a-2c.

As shown in Figure 14, an electromagnetic wave is generated by the vibration detector 1A and irradiated on the target conductors for detecting whether the current is flowing, i.e, either AC current mode or DC current mode. By irradiating the electromagnetic wave, the conductors 3a-3c of the electrical equipment 2a-2c vibrate under equations (18) - (20) when they are in the AC current mode, and vibrate under equation (24) when they are in the DC current mode.

The vibration detector 1 receives the reflected wave from the target conductors on which the electromagnetic wave is irradiated, and detects a frequency of vibration of the conductors 3a-3c of the electrical equipment 2a-2c by the difference between the frequency of the incident wave and the frequency of the reflected wave. Then, the processor 4 processes the vibration of the target conductors detected by the vibration detector 1, and supplies the result to the display 5 and speaker 6 in the output unit 12.

In Figure 14, the conductors 3a-3c of the electrical equipment 2a-2c are in the current mode, where the electric current of 30.0A is flowing therethrough. On the display 5 of the output unit 12, an image of the conductors 3a and 3b in the current mode is displayed in a predetermined color, and the current value is displayed numerically close to the image. The above example is directed to the detection of the current mode, however, the same arrangement can be applied to a case for detecting the voltage mode.

According to this embodiment, the electromagnetic wave that generates a forced vibration of the conductors 3a and 3b of the electrical equipment 2a and 2b is used as a detecting wave irradiated by the vibration detector 1A. Since this wave is used both for detecting and generating the vibration, the electromagnetic wave generator 16 does not have to be prepared separately.

The voltage and current mode detection apparatus 15 of the present invention can be structured in a small package as a portable device so that one person can carry it around anywhere. The voltage and current mode detection apparatus 15 installs the vibration detector 1, electromagnetic wave generator 16, processor 4, liquid crystal display 5, and speaker 6 in one unit.

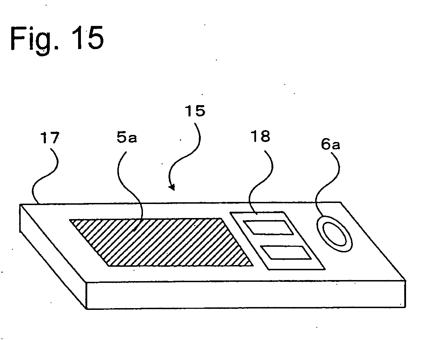

Figure 15 shows an example of outside view of the voltage and current mode detection apparatus of the present invention. Within a housing 17, the voltage and current mode detection apparatus 15 includes the vibration detector 1, electromagnetic wave generator 16, processor 4, liquid crystal display 5, and speaker 6. A control panel 18 for controlling the vibration detector 1 and electromagnetic wave generator 16 is provided on an upper surface of the housing 17. A screen 5a of the liquid crystal display 5 and an output 6a of the speaker 6 are also provided on the surface of the housing 17. Other components such as an antenna (not shown) for receiving and transmitting the waves can be mounted, for example, on a right side of the voltage and current mode detector 15.

Therefore, the workers can operate a portable voltage and current detector 15, in an electric station, to irradiate a laser beam toward the direction of the conductor 3 of the electrical equipment 2. Since the conductor 3 can be displayed by images or pictures with colors, the voltage mode and/or current mode of the conductors can be grasped quickly and instinctively. As a result, overlook of the conductor in the voltage or current mode or the illusion of it can be effectively prevented, which improves the safety of handling the electricity.

According to the present invention described above, the visualization of the status of electricity is achieved from a distance, i.e., in a contactless manner, by irradiating a laser beam on the conductors of the electrical equipment, detecting the vibration, and providing the detected result to the output unit. As a result, the workers assigned to use or maintain the electrical equipment can properly grasp the voltage and current status thereof.

Furthermore, the vibration is forcefully produced on the conductors of the electrical equipment in either the voltage or current mode upon irradiating the electromagnetic wave of the selected frequency, and the amplitude of the resultant vibration is detected from a distance to identify either the voltage or current mode. Therefore, voltage and current status can be examined even if the target conductor is in the DC current mode where it is difficult to generate the self-excited vibration. Also, since the frequency of the electromagnetic wave can be selected in a range where no communication waves are used, detection can be conducted in a range of low noise and high sensitivity. Thus, the voltage and current mode detection apparatus 15 of the present invention can accurately detect the voltage mode or current mode even when the voltage or current is small.

As a result, accidents such as electric shocks can be avoided in the electrical equipment in factories, buildings, homes, railroads, vehicles, ships, and etc., thereby improving the safety in handling the electricity as well as improving working efficiencies.

Although the invention is described herein with reference to the preferred embodiment, one skilled in the art will readily appreciate that various modifications and variations may be made without departing from the spirit and scope of the present invention. Such modifications and variations are considered to be within the purview and scope of the appended claims and their equivalents.

## Claims

1. An apparatus for detecting a voltage and current status of conductors of electrical equipment as to whether in a voltage mode or a current mode, comprising:

   a vibration detector for irradiating a wave on the conductors of the electrical equipment and detecting a vibration of the conductors based on a frequency of an incident wave and a frequency of a reflected wave;
   a processor for determining either the voltage mode or current mode when an amplitude of a specific frequency extracted from the vibration of the conductors exceeds a predetermined value; and
   an output unit for indicating the voltage mode or current mode determined by the processor;

   wherein the voltage mode is defined as a status where a voltage is applied to the conductors while no current is flowing the conductors, and the current mode is defined as a status where a voltage is applied to the conductors and a current is flowing through the conductors.

2. An apparatus for detecting a voltage and current status of conductors as defined in Claim 1, wherein said output unit is comprised of a display apparatus for displaying the voltage mode or current mode determined by the processor with use of a predetermined color or numeric value.

3. An apparatus for detecting a voltage and current status of conductors as defined in Claim 1, wherein said output unit is comprised of a speaker for generating a predetermined sound message corresponding to the voltage mode or current mode determined by the processor.

4. An apparatus for detecting a voltage and current status of conductors as defined in Claim 2, further comprising a camera for filming an image of the electrical equipment, and the display apparatus displays the color or numeric value filmed by the camera corresponding to the vibration of the electrical equipment.

5. An apparatus for detecting a voltage and current status of conductors of electrical equipment as to whether in a voltage mode or a current mode, comprising:

an electromagnetic wave generator for irradiating an electromagnetic wave of a selected frequency on the conductors of the electrical equipment and detecting a vibration of the conductors based on a frequency of an incident wave and a frequency of a reflected wave;
a processor for determining either the voltage mode or current mode when an amplitude of a specific frequency extracted from the vibration of the conductors exceeds a predetermined value; and
an output unit for indicating the voltage mode or current mode determined by the processor;

wherein the voltage mode is defined as a status where a voltage is applied to the conductors while no current is flowing the conductors, and the current mode is defined as a status where a voltage is applied to the conductors and a current is flowing through the conductors.

6. An apparatus for detecting a voltage and current status of conductors as defined in Claim 5, wherein said output unit is comprised of a display apparatus for displaying the voltage mode or current mode determined by the processor with use of a predetermined color or numeric value.

7. An apparatus for detecting a voltage and current status of conductors as defined in Claim 5, wherein said output unit is comprised of a speaker for generating a predetermined sound message corresponding to the voltage mode or current mode determined by the processor.

8. An apparatus for detecting a voltage and current status of conductors as defined in Claim 6, further comprising a camera for filming an image of the electrical equipment, and the display apparatus displays the color or numeric value filmed by the camera corresponding to the vibration of the electrical equipment.

9. An apparatus for detecting a voltage and current status of conductors of electrical equipment as to whether in a voltage mode or a current mode, comprising:

a vibration detector for irradiating an electromagnetic wave of a selected frequency on the conductors of the electrical equipment and detecting a vibration of the conductors based on a frequency of an incident wave and a frequency of a reflected wave;
a processor for determining either the voltage mode or current mode when an amplitude of a specific frequency extracted from the vibration of the conductors exceeds a predetermined value; and
an output unit for indicating the voltage mode or current mode determined by the processor;

wherein the voltage mode is defined as a status where a voltage is applied to the conductors while no current is flowing the conductors, and the current mode is defined as a status where a voltage is applied to the conductors and a current is flowing through the conductors.

10. An apparatus for detecting a voltage and current status of conductors as defined in Claim 9, wherein said output unit is comprised of a display apparatus for displaying the voltage mode or current mode determined by the processor with use of a predetermined color or numeric value.

11. An apparatus for detecting a voltage and current status of conductors as defined in Claim 9, wherein said output unit is comprised of a speaker for generating a predetermined sound message corresponding to the voltage mode or current mode determined by the processor.

12. An apparatus for detecting a voltage and current status of conductors as defined in Claim 10, further comprising a camera for filming an image of the electrical equipment, and the display apparatus displays the color or numeric value filmed by the camera corresponding to the vibration of the electrical equipment.

# Fig. 1

# Fig. 2

10

Camera — 10

Vibration Detecter — 1

4

7

8

Display Processing Unit — 8

5

Display — 5

12

S

Vibration Determining Unit

Output Sound Processing Unit — 9

Speaker — 6

14

Input Unit — 14

Memory — 13

6

# Fig. 3

2a

3a

+

+

2b

3b

←

Repulse →

11a

11b

3a

2a

−

−

3b

Repulse

←

→

2b

11a

11b

Fig. 4

Volatage

+ + +

− −

t

Repulsion

t

Fig. 5

Volatage

100Hz
(120Hz)

Hz

No Voltage

Hz

Fig. 6

Fig. 7

## Fig. 8

Current

+      + 

t

−    −

No Current

t

## Fig. 9

Current

Hz

100Hz
(120Hz)

No Current

Hz

Fig. 10

## Fig. 11

$F_1$

$F_{22}$  $F_{21}$

$2\omega_1$  $|\omega_1 - \omega_2|$  $\omega_1 + \omega_2$

## Fig. 12

$F_{11}$  $F_{12}$  $F_3$

$\omega_2$

## Fig. 13

$F_3$

$\omega_2$

Fig. 14

## Fig. 15